# FASCICULE DE BREVET EUROPEEN

(11) **EP 2 553 149 B1**
(45) Date de publication et mention de la délivrance du brevet: **18.10.2017**
(21) Numéro de dépôt: 11712510.4
(22) Date de dépôt: 25.03.2011
(51) Int. Cl.: C25F 3/12, H01L 31/0224

(54) **PROCÉDÉ POUR GRAVER UNE COUCHE D'OXYDE MÉTALLIQUE CONDUCTEUR UTILISANT UNE MICROÉLECTRODE**
ÄTZVERFAHREN FÜR LEITENDE METALLOXIDSCHICHT MIT EINER MIKROELEKTRODE
METHOD FOR ETCHING CONDUCTIVE METAL OXIDE LAYER USING MICROELECTRODE

(30) Priorité: 26.03.2010 FR 1052227
(43) Date de publication de la demande: 06.02.2013
(73) Titulaire: Commissariat à l'Énergie Atomique et aux Énergies Alternatives, 75015 Paris (FR)
(72) Inventeur: METAYE, Romain, F-92310 Sevres (FR); GRISOTTO, Federico, F-78870 Bailly (FR)
(74) Mandataire: Ilgart, Jean-Christophe
(86) Numéro de dépôt international: PCT/EP2011/054653
(87) Numéro de publication internationale: WO 2011/117407

(56) Documents cités:
- US-A- 5 149 404
- US-A- 5 641 391
- LIN C W ET AL: "HIGH RESOLUTION PHOTOELECTROCHEMICAL ETCHING OF N-GAAS WITH THE SCANNING ELECTROCHEMICAL AND TUNNELING MICROSCOPE", JOURNAL OF THE ELECTROCHEMICAL SOCIETY, ELECTROCHEMICAL SOCIETY. MANCHESTER, NEW HAMPSHIRE, US, vol. 134, no. 4, 1 avril 1987 (1987-04-01) , XP000840129, ISSN: 0013-4651
- MANDLER D ET AL: "HIGH RESOLUTION ETCHING OF SEMICONDUCTORS BY THE FEEDBACK MODE OF THE SCANNING ELECTROCHEMICAL MICROSCOPE", JOURNAL OF THE ELECTROCHEMICAL SOCIETY, ELECTROCHEMICAL SOCIETY. MANCHESTER, NEW HAMPSHIRE, US, vol. 137, no. 8, 1 août 1990 (1990-08-01), pages 2468-2472, XP000151183, ISSN: 0013-4651

## Description

### DOMAINE TECHNIQUE

La présente invention appartient au domaine des conducteurs et notamment des conducteurs transparents dans le domaine du visible et du proche infrarouge tels que des couches (ou films) d'oxyde d'indium dopé à l'étain ou couches d'ITO (pour « Indium-Tin Oxide »).

Elle concerne, plus particulièrement, un procédé pour graver une couche d'oxyde métallique conducteur en présence d'une microélectrode et en mettant en oeuvre des solutions convenablement sélectionnées afin de permettre une gravure nette, précise et reproductible de cette couche.

### ÉTAT DE LA TECHNIQUE ANTÉRIEURE

L'ITO est un semiconducteur dégénéré de type n dont la transparence notamment dans le visible est due à la large bande interdite supérieure à 3,5 eV. La conductivité électrique de l'ITO résulte de l'apport de porteurs de charge tels que des électrons sur des niveaux proches du bas de la bande de conduction, d'une part, par création de lacunes d'oxygène et, d'autre part, par substitution, dans le réseau cristallin, d'ions indium par des ions étain.

Ainsi, les couches minces d'ITO sont électriquement conductrices et optiquement transparentes dans le domaine du visible. De par ces caractéristiques, elles ont trouvé un large champ d'applications en tant que matériau d'électrodes dans toute technologie qui nécessite des électrodes conductrices et transparentes. Parmi les applications dans lesquelles des couches d'ITO peuvent être mises en oeuvre, on peut citer les capteurs ou détecteurs optiquement transparents **[1],** les capteurs ou détecteurs bioélectroniques **[2],** la micro/nano-structuration des dispositifs optiques mais également la technologie des écrans pour les écrans tactiles, les cellules solaires, les afficheurs à cristaux liquides, les diodes électroluminescentes, les diodes électroluminescentes organiques, les dispositifs de chauffage de vitres, miroirs ou lentilles etc...

Ces applications nécessitent, pour la plupart, la gravure des couches (ou films) d'ITO avec élimination sélective d'une partie de ces couches. A cet effet, il est possible d'utiliser des procédés soit de gravure humide, soit de gravure sèche.

La gravure humide est largement utilisée car elle propose un procédé rapide et de faible coût. Cette technique est basée sur la photolithographie pour réaliser une ablation de la surface du substrat. Elle peut être appliquée à de grandes surfaces avec une bonne reproductibilité. Cependant, un certain nombre d'inconvénients existent tels que des problèmes de gravure sélective à la frontière entre les grains et de gravure isotropique i.e. la gravure se faisant dans toutes les directions de l'espace. Des petites variations dans la couche génèrent des résidus d'ITO après la gravure et provoquent également l'attaque latérale des couches d'ITO. Ceci peut détériorer les propriétés électriques de l'électrode en ITO et entraîner des formes non contrôlables quant aux bordures de la couche d'ITO gravée. De plus, la gravure humide nécessite l'utilisation de solutions d'acides forts tels que des acides halogénés ou de l'eau régale, qui peuvent endommager le film ou le substrat sur lequel la couche d'ITO a été déposée **[3].** La gravure humide nécessite également l'utilisation d'un masque pour protéger les zones de la couche d'ITO ne devant pas être éliminées. L'utilisation d'un masque alourdit non seulement le procédé avec nécessité d'étapes supplémentaires telles que préparation, mise en place et élimination du masque mais aussi le coût du procédé.

La gravure sèche met notamment en oeuvre le dépôt de la couche d'ITO par pulvérisation au-dessus de masques et la sérigraphie. Un autre procédé simple et efficace de gravure sèche est la gravure au laser qui ne nécessite pas, quant à elle, l'utilisation de masques. La photoénergie du laser entraîne la vaporisation de la couche d'ITO et donc un modelage (ou « patterning ») propre de la couche d'ITO. Toutefois, même si la couche d'ITO peut être complètement enlevée avec une seule et unique impulsion laser, la vapeur d'ITO peut se redéposer, après la gravure, sur la surface gravée **[4].** De même, l'énergie du laser peut endommager le substrat (ou support) sur lequel la couche d'ITO a été déposée.

Enfin, que la gravure mise en oeuvre soit humide ou sèche, la résolution finale obtenue est de l'ordre de 1 µm. En d'autres termes, ces procédés permettent d'obtenir des gravures (ou traits en relief) de la couche d'ITO présentant une largeur minimale de 1 µm.

Compte tenu du potentiel actuel des couches d'ITO et de leurs applications, il existe un réel besoin quant à un procédé qui permette de graver des couches d'ITO de façon reproductible et précise et ce, sans endommager le support sur lequel la couche d'ITO a été déposée.

### EXPOSÉ DE L'INVENTION

La présente invention permet de résoudre ce problème technique et les inconvénients des procédés de l'état de la technique. Plus particulièrement, la présente invention permet de résoudre les problèmes techniques précédemment listés en utilisant une microélectrode et une solution électrochimique pour graver une couche d'ITO déposée sur un support solide.

Plusieurs avantages quant à l'utilisation d'une microélectrode pour graver une telle couche existent. En effet, tout comme la gravure sèche au laser, cette technique est mise en oeuvre sans masque. Un quelconque motif peut être gravé rapidement notamment lorsque la microélectrode est couplée à un programme de dessins.

L'utilisation d'une microélectrode permet un procédé de gravure en continu (ou « roll to roll process ») mais aussi un procédé de gravure feuille par feuille (ou « sheet by sheet process »).

De plus, l'utilisation d'une microélectrode permet d'obtenir une gravure nette avec des entailles présentant des bordures droites et ce, sans redépôt des parties enlevées. Enfin, le support sur lequel la couche d'ITO a été déposée n'est nullement endommagé par une gravure utilisant une microélectrode.

De façon particulièrement intéressante, le procédé de gravure selon la présente invention s'applique non seulement aux couches d'ITO mais également à toute couche en oxyde métallique conducteur de l'électricité que cette dernière soit opaque ou transparente telle que des couches d'OTC pour « Oxyde Transparent et Conducteur » (ou TCO en anglais).

La présente invention concerne donc un procédé pour graver une zone sélectionnée d'une couche d'un oxyde métallique conducteur de l'électricité déposée sur un support consistant à éliminer ladite zone par voie électrochimique en présence d'une microélectrode polarisée.

Dans le cadre de la présente invention, les expressions « conducteur de l'électricité » et « conducteur » sont équivalentes et peuvent être utilisées de façon interchangeable.

Par « procédé pour graver », on entend un procédé permettant d'enlever ou d'éliminer au moins une zone de la couche d'oxyde métallique conducteur pour créer un motif éventuellement prédéterminé en oxyde métallique conducteur à la surface du support.

La zone de la couche d'oxyde métallique conducteur enlevée est avantageusement éliminée jusqu'à la surface du support créant ainsi des motifs d'oxyde métallique conducteur sur la surface du support.

En variante, la gravure de la couche d'oxyde métallique conducteur peut être partielle, une simple portion de l'épaisseur de la couche d'oxyde métallique ayant été enlevée par le procédé selon l'invention. Cette variante peut être utilisée pour obtenir une surface d'oxyde métallique conducteur plus rugueuse et en augmenter ainsi la surface spécifique.

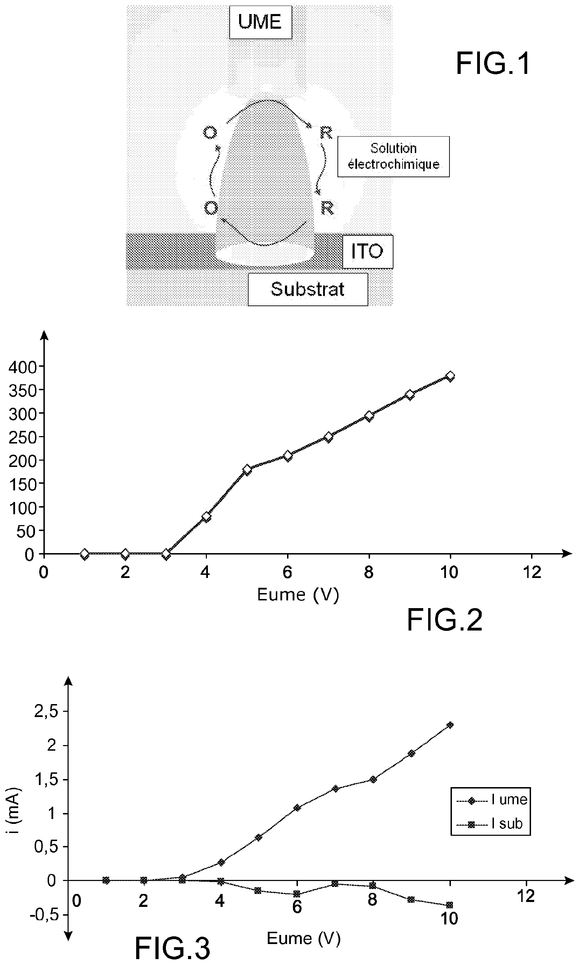

Par « voie électrochimique en présence d'une microélectrode polarisée », on entend, dans le cadre de la présente invention, une gravure ou microgravure de la couche d'oxyde métallique conducteur par des espèces actives telles que des espèces radicalaires et/ou ioniques et notamment anioniques générées dans la solution électrochimique sous l'action de la microélectrode polarisée. Ces espèces actives sont capables de réagir avec l'oxyde métallique et de l'attaquer chimiquement de façon à l'éliminer. La Figure 1 est une schématisation du procédé selon la présente invention avec un support en verre (Substrat) revêtu d'une couche d'ITO (ITO) mis en présence d'une solution électrochimique et d'une microélectrode telle qu'une ultramicroélectrode (UME), la forme oxydée (O) d'un composé étant réduite en la forme réduite (R) de ce composé au niveau de la UME et la forme réduite (R) étant oxydée en la forme oxydée (O) au niveau de la couche d'ITO.

Compte tenu de la définition « voie électrochimique en présence d'une microélectrode polarisée », la présente invention concerne, en d'autres termes, un procédé pour graver une zone sélectionnée d'une couche d'un oxyde métallique conducteur de l'électricité déposée sur un support consistant à éliminer ladite zone par voie électrochimique en présence d'une microélectrode polarisée et d'une solution électrochimique.

Le support mis en oeuvre dans le cadre du procédé selon l'invention i.e. le support à la surface duquel la couche d'oxyde métallique conducteur est déposée peut être tout support solide naturel ou synthétique, notamment utilisé comme support d'électrodes. Tout support non soluble dans l'eau est utilisable dans le cadre de la présente invention, ce dernier pouvant notamment être en polymère(s) ou se présenter sous forme d'une couche inorganique.

Avantageusement, le support mis en oeuvre dans le cadre de la présente invention est un support isolant. De même, ce support peut être opaque ou transparent dans le visible et le proche infrarouge. Par « transparent dans le visible et le proche infrarouge », on entend, dans le cadre de la présente invention, un matériel permettant la transmission d'au moins 50%, notamment d'au moins 60%, en particulier, d'au moins 70% et, plus particulièrement, d'au moins 80% d'une lumière présentant une longueur d'onde comprise entre environ 400 et environ 1400 nm et notamment entre environ 400 et environ 800 nm.

Plus particulièrement, le support mis en oeuvre dans le cadre de la présente invention est un support en verre ou un substrat flexible transparent dans le visible et le proche infrarouge tel qu'un substrat en polymère flexible transparent dans le visible et le proche infrarouge.

Ainsi, le support mis en oeuvre dans le cadre de la présente invention est en un matériau choisi dans le groupe constitué par le verre, un polycarbonate tel que le bisphénol A polycarbonate, un polyacrylate tel que le poly(méthyl méthacrylate), un polyamide tel que le nylon, un polyester tel que le polyéthylène téréphtalate (PET), un polyarylate, un styrénique, un polyetherimide, un polymère sulfonique, un polyéther imide, un polyimide, un polynorbornène, un polymère oléfinique, un polymère liquide cristallin (ou LCP) tel que du polyétheréthercétone (ou PEEK), du polyphénylène éther (ou PPE) ou du polyphénylène oxyde (ou PPO) et un polymère thermodurcissable transparent.

L'oxyde métallique conducteur de l'électricité mis en oeuvre dans le cadre de la présente invention peut être opaque ou transparent dans le visible et le proche infrarouge. Avantageusement, cet oxyde métallique conducteur est transparent dans le visible et le proche infrarouge. Ainsi, l'oxyde métallique conducteur mis en oeuvre dans le cadre de la présente invention est un oxyde transparent et conducteur (OTC).

L'oxyde métallique conducteur mis en oeuvre dans le cadre de la présente invention est choisi dans le groupe constitué par un oxyde d'indium éventuellement dopé, un oxyde d'étain éventuellement dopé, un oxyde de zinc éventuellement dopé, un oxyde de cadmium éventuellement dopé, un oxyde de gallium éventuellement dopé, un oxyde de thallium éventuellement dopé, un oxyde de plomb éventuellement dopé, un oxyde d'antimoine éventuellement dopé, un oxyde de niobium éventuellement dopé, un oxyde de tungstène éventuellement dopé, un oxyde de zirconium éventuellement dopé, un oxyde de ruthénium éventuellement dopé, un oxyde de baryum éventuellement dopé, un oxyde de sélénium éventuellement dopé, un oxyde de bismuth éventuellement dopé et leurs mélanges.

Par « éventuellement dopé », on entend un oxyde métallique conducteur comprenant en outre un constituant susceptible de le doper.

Avantageusement, l'oxyde métallique conducteur mis en oeuvre dans le cadre de la présente invention est choisi dans le groupe constitué par l'oxyde d'étain dopé au fluor (SnO₂:F), l'oxyde d'étain dopé à l'arsenic (SnO₂:As), l'oxyde d'étain dopé à l'antimoine (SnO₂:Sb), l'oxyde d'indium dopé à l'étain (ITO) et l'oxyde d'indium dopé au zinc (IZO). De façon plus avantageuse encore, la couche d'oxyde métallique conducteur mise en oeuvre dans le cadre de la présente invention est une couche d'ITO, cette couche étant de structure majoritairement amorphe et notamment synthétisée à partir d'un matériau constitué d'un mélange 90% In₂O₃ et 10% SnO₂ (pourcentages exprimés en masse par rapport à la masse totale du matériau).

La couche d'oxyde métallique conducteur susceptible d'être gravée par le procédé selon la présente invention peut présenter une épaisseur plus ou moins grande. Cette épaisseur peut être variable sur le support. Toutefois, une épaisseur constante sur tout le support est avantageuse. En particulier, cette épaisseur est comprise entre 10 et 1000 nm, notamment entre 20 et 800 nm, en particulier, entre 50 et 600 nm et, plus particulièrement, entre 100 et 400 nm.

L'homme du métier connait différentes techniques permettant le dépôt d'une telle couche d'un oxyde métallique conducteur sur un support, ladite couche étant en contact direct avec la surface du support. A titre d'exemples illustratifs et non limitatifs, on peut citer un dépôt par pulvérisation cathodique, un dépôt par pulvérisation ionique et un dépôt de couches atomiques (technique ALD).

Au sens de la présente invention, une « microélectrode » (ou ME) correspond à une électrode dont au moins une des dimensions caractéristiques (le diamètre pour un disque) est au maximum de l'ordre de quelques dizaines de micromètres. Plus généralement, l'ensemble des dimensions d'une ME est au maximum de l'ordre de quelques dizaines de micromètres. Parmi les ME, on distingue les « ultramicroélectrodes » (UME) dont une des dimensions caractéristiques (diamètre pour un disque) est au maximum de l'ordre de quelques dizaines de nanomètres. Généralement au moins deux des dimensions d'une UME sont au maximum de l'ordre de quelques dizaines de nanomètres.

Dans les ME, le courant mesuré aux temps longs est stationnaire ou quasistationnaire (décroissance logarithmique). La chute ohmique est négligeable lorsque de telles électrodes sont utilisées. Le courant mesuré est constant dans le temps et dépend de la concentration en espèces redox.

A titre de microélectrode utilisable dans le cadre de la présente invention, il est possible d'employer avantageusement la sonde d'un microscope électrochimique à balayage (SECM) ou d'un microscope à force atomique en mode électrochimique (AFM-SECM). Avantageusement, on emploiera une ME, correspondant à la sonde d'un microscope, dont le diamètre est inférieur à 200 µm, notamment inférieur à 100 µm, en particulier inférieur à 50 µm et voire inférieur à 25 µm. L'utilisation d'une microélectrode présentant un diamètre inférieur à 25 µm permet de réduire encore la largeur de la gravure obtenue.

La microélectrode mise en oeuvre peut présenter des formes variées. Elle peut notamment correspondre à un disque, une sphère, un hémisphère, une micropipette, un peigne inter-digité, un cône, un anneau, des anneaux concentriques ou encore une bande. Sa forme peut ainsi correspondre à un motif quelconque et être homothétique aux contours de la zone à graver. La gravure locale de la couche d'ITO peut ainsi être réalisée avec une microélectrode préformée pour obtenir directement la forme désirée.

Par conséquent, la microélectrode mise en oeuvre dans le procédé objet de la présente invention est avantageusement choisie dans le groupe constitué par une ultramicroélectrode (UME), la sonde d'un microscope électrochimique à balayage (SECM) et la sonde d'un microscope à force atomique en mode électrochimique (AFM-SECM).

La largeur de la zone gravée obtenue par mise en oeuvre du procédé selon la présente invention est avantageusement comprise entre 10 µm et 1 cm, notamment entre 50 µm et 100 mm, en particulier, entre 100 µm et 10 mm et, plus particulièrement entre 100 µm et 1 mm. Il convient de noter qu'il est possible d'obtenir des zones gravées plus larges en réalisant plusieurs gravures successives et adjacentes.

L'invention concerne plus particulièrement un procédé pour graver une zone sélectionnée d'une couche d'oxyde métallique conducteur déposée sur un support, comprenant les étapes suivantes :
a) positionnement d'une microélectrode à proximité de la surface de la zone sélectionnée ;
b) mise en contact d'une solution électrochimique, avec au moins ladite zone sélectionnée ;
c) polarisation de ladite microélectrode et éventuellement de ladite couche d'oxyde métallique conducteur.

En général, la séquence d'étapes est soit (a), (b) et (c), soit (a), (c) et (b).

Le positionnement de la microélectrode lors de l'étape (a) du procédé objet de la présente invention est généralement effectué en plaçant la ME à la verticale de la surface de la zone de la couche d'oxyde métallique à graver i.e. à éliminer. La ME est placée à une distance non nulle par rapport à la couche d'oxyde métallique. Cette distance est avantageusement maintenue constante notamment lorsque la ME se déplace au-dessus de la couche d'oxyde métallique.

La distance entre la ME et la couche d'oxyde métallique est déterminée, selon la méthode usuellement employée en microscopie électrochimique, à l'aide d'un médiateur électrochimique correspondant à un couple (oxydant/réducteur) réversible connu tel que le système Fe³⁺/Fe²⁺. Une courbe, dite « courbe d'approche », correspondant à la valeur du courant du médiateur à la ME en fonction de la distance entre la ME et la couche d'oxyde métallique, est tout d'abord réalisée.

La distance de travail (i.e. la distance entre la ME et, plus particulièrement, entre la pointe de la ME et la couche d'oxyde métallique conducteur) choisie pour effectuer le procédé est une distance dite de *feedback* où la ME et la surface ont des interactions. Dans ces conditions, le rapport entre la valeur de l'intensité du courant mesurée à la distance de travail et celle du courant mesurée à l'infini, *i.e.* loin de la couche d'oxyde métallique, est compris entre 1,2 et 20. En général, une telle valeur correspond à une distance telle que le rapport entre la distance de travail et le rayon de la ME est compris entre 0,1 et 2, notamment entre 0,15 et 1 et, en particulier, entre 0,2 et 0,8. Généralement, pour une ME dont le diamètre est compris entre 20 à 150 µm, la distance de travail sera comprise entre 4 et 100 µm, notamment entre 8 et 80 µm et typiquement entre 10 et 40 µm.

Dans une première forme de mise en oeuvre, la solution électrochimique, ci-après également désignée solution électrolytique, mise en oeuvre dans le cadre de la présente invention comprend au moins un acide carboxylique.

Par « acide carboxylique », on entend un composé chimique comprenant au moins un groupement -COOH.

Dans une première variante, ce composé chimique ne comprend qu'un groupement -COOH. Dans cette variante, le composé chimique peut comprendre en outre une insaturation éthylénique.

Dans une seconde variante, ce composé chimique comprend au moins 2 groupements -COOH et notamment 3 ou 4 groupements -COOH. Dans cette variante, le composé chimique peut comprendre en outre une insaturation éthylénique.

En tenant compte de ces deux variantes, l'acide carboxylique mis en oeuvre dans la solution électrochimique est choisi dans le groupe constitué par l'acide carbonique, l'acide acétique, l'acide propanoïque, l'acide butanoïque, l'acide acrylique, l'acide méthacrylique, l'acide méthyl méthacrylique, l'acide éthacrylique, l'acide alpha-chloroacrylique, l'acide alpha-cyano acrylique, l'acide crotonique, l'acide alpha-phényl acrylique, l'acide sorbique, l'acide alpha-chloro sorbique, l'acide angélique, l'acide cinnamique, l'acide p-chloro cinnamique, l'acide itaconique, l'acide citraconique, l'acide mésaconique, l'acide glutaconique, l'acide aconitique, l'acide fumarique, le tricarboxy éthylène, l'acide oxalique, l'acide maléique, l'acide benzène tétracarboxylique, l'acide 1,2,3,4-butane tétracarboxylique et l'acide 1,2,3-propane tricarboxylique. Avantageusement, l'acide carboxylique mis en oeuvre dans le cadre de la présente invention est de l'acide acrylique.

Quel que soit l'acide carboxylique mis en oeuvre, ce dernier est présent dans la solution électrochimique en une quantité comprise entre 50 mM et 10 M, notamment entre 100 mM et 8 M, en particulier, entre 500 mM et 6 M et, plus particulièrement, entre 1 et 4 M.

Dans une seconde forme de mise en oeuvre, la solution électrochimique utilisée dans le cadre de la présente invention comprend au moins un acide faible. Avantageusement, ledit acide faible présente un pKa supérieur à 4, notamment compris entre 4 et 13 et, en particulier, entre 4 et 9.

La valeur du pKa, qui correspond à -log₁₀(Ka) avec Ka représentant la constante d'ionisation, d'un acide est soit connue de l'homme du métier car donnée dans des ouvrages de référence, soit accessible de façon expérimentale par des techniques notamment pHmétriques bien connues de l'homme du métier.

A titre d'exemples non limitatifs d'acides faibles susceptibles d'être mis en oeuvre dans le cadre de la présente invention, on peut citer l'acide borique, l'acide sulfhydrique, l'ion pyridinium et le dihydrophosphate. Il convient de noter que certains des acides carboxyliques précédemment listés sont également des acides faibles dans le sens de la présente invention.

Quel que soit l'acide faible mis en oeuvre, ce dernier est présent dans la solution électrochimique en une quantité comprise entre 10 mM et 10 M et notamment entre 100 mM et 6 M.

Dans une troisième forme de mise en oeuvre, la solution électrochimique mise en oeuvre dans le cadre de la présente invention comprend au moins un composé apte à chélater (complexer) au moins un ion métallique.

Ce composé est soit une entité apte à chélater (complexer) au moins un ion métallique, soit comprend un groupement apte à chélater (complexer) au moins un ion métallique. Cette entité (ou ce groupement) est une structure moléculaire neutre permettant la complexation des cations, i.e. une structure présentant des doublets libres, donc contenant des atomes d'azote non quaternisés, des atomes de soufre ou des atomes d'oxygène. Avantageusement, une entité (ou un groupement) apte à chélater (complexer) au moins un ion métallique est choisi(e) dans le groupe constitué par un groupement parmi les amines, les amides, les éthers, les carbonyles, les carboxyles, les carboxylates, les phosphines, les oxydes de phosphines, les thio-éthers, les disulfures, les urées, les éther-couronnes, les aza-couronnes, les thio-couronnes, les cryptands, les sépulcrands (en anglais « sepulcrates »), les podands, les porphyrines comme la tétrakis (acide bezoïque)-4,4',4",4'''-(porphyrine-5,10,15,20-tetrayle), les calixarènes comme le calix[4]arène, les pyridines, les bipyridines, les terpyridines, les quinoléines, les composés de l'orthophénantroline, les naphtols, les iso-naphtols, les thiourées, les sidérophores, les antibiotiques, l'éthylène glycol, les cyclodextrines (CD) comme les cyclodextrines naturelles et les dérivés de peranhydrocyclodextrines, ainsi que les structures moléculaires substituées et/ou fonctionnalisées à partir de ces groupes fonctionnels, et/ou une ou plusieurs cavité(s) complexante(s) de type verrous redox. Pour plus de détails sur de tel(le)s entités (ou groupement), l'homme du métier pourra consulter les demandes de brevet FR 2 813 208 et FR 2 851 181 **[6, 7].**

Le composé apte à chélater (complexer) au moins un ion métallique est présent dans la solution électrochimique en une quantité comprise entre 10 mM et 10 M et notamment entre 100 mM et 6 M.

Il est clair que la solution électrochimique mise en oeuvre dans le cadre de la présente invention peut contenir plusieurs éléments choisis parmi les acides carboxyliques, les acides faibles et les composés aptes à chélater (complexer) au moins un ion métallique, tels que précédemment définis.

La solution électrochimique mise en oeuvre dans le cadre de la présente invention comprend un solvant et ce, dans les trois formes de mise en oeuvre précédemment envisagées. Ce solvant est avantageusement un solvant protique.

Par « solvant protique », on entend, dans le cadre de la présente invention, un solvant qui comporte au moins un atome d'hydrogène susceptible d'être libéré sous forme de proton.

Le solvant protique est avantageusement choisi dans le groupe constitué par l'eau, et particulièrement l'eau désionisée, l'eau distillée, acidifiées ou non ; les solvants hydroxylés comme le méthanol et l'éthanol ; les glycols liquides, particulièrement ceux de faible poids moléculaire tels que l'éthylèneglycol, et leurs mélanges. Dans une première variante, le solvant protique utilisé dans le cadre de la présente invention n'est constitué que par un solvant protique ou par un mélange de différents solvants protiques. Dans une autre variante, le solvant protique ou le mélange de solvants protiques peut être utilisé en mélange avec au moins un solvant aprotique, étant entendu que le mélange résultant présente les caractéristiques d'un solvant protique et sera à ce titre considéré comme tel.

Plus particulièrement, le solvant protique mis en oeuvre dans la solution électrochimique est choisi dans le groupe constitué par l'eau, l'eau désionisée, l'eau distillée, l'eau acidifiée, l'eau désionisée acidifiée et l'eau distillée acidifiée.

Par « acidifiée », on entend de l'eau comprenant en outre un acide tel que de l'acide chlorhydrique, de l'acide nitrique ou de l'acide sulfurique. La quantité d'acide dans la solution électrochimique est comprise entre 1 mM et 1 M, notamment entre 50 mM et 500 mM et, en particulier, entre 100 mM et 300 mM.

L'homme du métier saura choisir le solvant de la solution électrochimique le mieux adapté en fonction notamment du support mis en oeuvre. Ainsi, si le support est en verre, il est possible d'utiliser de l'eau acidifiée. Par contre, si le support est un plastique, la présence d'acide dans le solvant pouvant entraîner une dégradation du support, de l'eau non acidifiée sera préférée.

Les travaux des inventeurs ont montré que la seule polarisation de la microélectrode lors de l'étape (c) du procédé permet d'obtenir une gravure nette mais dégrade l'état chimique de la surface. En effet, travailler sans polarisation de la couche d'oxyde métallique conducteur, i.e. lorsque la couche d'oxyde métallique conducteur est déconnectée, entraîne des modifications du type dégradations sur toute la surface de la couche d'oxyde métallique (état chimique).

D'un point de vue mécanistique, des espèces réactives sont générées dans la solution électrochimique par voie électrochimique via la microélectrode polarisée. Si la couche d'oxyde métallique conducteur n'est pas connectée i.e. n'est pas polarisée, elle doit échanger des électrons avec la solution électrochimique et ce, en passant par toute sa surface. Une gravure localisée est effectuée, mais, dans ce cas, elle est couplée à une dégradation diffuse de la couche d'oxyde métallique conducteur.

Si, au contraire, la couche d'oxyde métallique conducteur est connectée i.e. est polarisée même faiblement, les électrons amenés par cette couche passent de la connexion à la surface jusqu'à la zone de réaction i.e. sous la microélectrode polarisée, sans traverser la surface entière. Il y a donc localisation de la gravure et respect de l'intégrité chimique de la surface de la couche d'oxyde métallique conducteur.

Par conséquent, l'étape (c) du procédé selon la présente invention présente deux variantes que sont :
- une étape (c) consistant en la polarisation de la microélectrode mais sans polarisation de la couche d'oxyde métallique conducteur ;
- une étape (c) consistant en la polarisation à la fois de la microélectrode et de la couche d'oxyde métallique conducteur.

Dans le cadre de la présente invention, le potentiel électrique employé à l'étape (c) du procédé pour la microélectrode et éventuellement pour la couche d'oxyde métallique conducteur sera principalement dépendant de la nature de la solution électrochimique mise en oeuvre. L'homme du métier saura déterminer, une fois la solution électrochimique choisie, au moyen d'essais de routine, le potentiel électrique à appliquer à la microélectrode et celui à éventuellement appliquer à la couche d'oxyde métallique conducteur. Ces essais de routine peuvent consister à mesurer soit la taille (ou la largeur) de la gravure en fonction du potentiel imposé à la microélectrode ou éventuellement à la couche d'oxyde métallique, soit le courant passant à travers les électrodes de travail que sont la microélectrode et la couche d'oxyde métallique si cette dernière est polarisée. Le type de résultats obtenus pour de tels essais sont présentés aux Figures 2 à 4 en annexe.

A titre d'exemples, lorsque la couche d'oxyde métallique conducteur est une couche d'ITO, le potentiel imposé à la microélectrode peut être avantageusement supérieur à 3 V, notamment compris entre 4 et 10 V et, en particulier, de l'ordre de 7 V (i.e. 7 ± 1 V).

A titre d'exemples, lorsque la couche d'oxyde métallique conducteur est une couche d'ITO, le potentiel imposé à cette couche est faible: il peut être avantageusement supérieur à - 1 V, notamment compris entre 0 et - 1 V et, en particulier, de l'ordre de - 0,1 V (i.e.- 0,1 ± 0, 05 V).

La polarisation de la microélectrode et éventuellement de la couche d'oxyde métallique peut être effectuée par toute technique connue de l'homme du métier et notamment en conditions de voltampérométrie linéaire ou cyclique, en conditions potentiostatiques, potentiodynamiques, intensiostatiques, galvanostatiques, galvanodynamiques ou par chronoampérométrie simple ou pulsée. Avantageusement, le procédé selon la présente invention est réalisé en conditions de chronoampérométrie statique ou pulsée. En mode statique, la microélectrode et/ou éventuellement la couche d'oxyde métallique sont polarisées pour une durée généralement inférieure à 5 sec, plus généralement durant 2 sec. En mode pulsé, le nombre de pulsations sera compris, de manière préférentielle, entre 2 et 100 et, encore plus préférentiellement, entre 1 et 20, leur durée étant généralement de 5 à 250 ms, typiquement 100 ms.

Dans le cadre de la présente invention, la microélectrode polarisée peut fonctionner en mode statique ou dynamique permettant de réaliser respectivement une gravure de type spot ou de type linéaire.

Ainsi, selon un mode de réalisation particulier, le procédé comporte une étape supplémentaire de déplacement de la microélectrode à proximité de la zone sélectionnée de la couche d'oxyde métallique conducteur. Avantageusement, cette étape supplémentaire (d) est mise en oeuvre après la séquence d'étapes (a), (b) et (c) ou (a), (c) et (b). Cette étape est utile lorsque la zone sélectionnée à graver présente une surface sensiblement plus importante que celle de la surface de la ME. Selon cette modalité, il est ainsi possible de graver, dans la couche d'oxyde métallique conducteur, des zones sélectionnées correspondant à des motifs complexes et vastes au regard de la taille de la ME.

Le déplacement de la microélectrode peut se faire à une vitesse continue ou variable dans le temps, une condition à considérer étant que la vitesse mise en oeuvre permette d'obtenir une gravure d'une qualité suffisante et notamment une gravure uniforme. Cette vitesse peut être notamment comprise entre 10 et 1000 µm/sec, en particulier, entre 50 et 700 µm/sec et, plus particulièrement, entre 100 et 500 µm/sec.

Ce but (i.e. gravure de motifs complexes et vastes au regard de la taille de la ME) peut également être atteint en utilisant plusieurs microélectrodes positionnées à proximité de la couche d'oxyde métallique conducteur à graver. La distance entre les microélectrodes sera choisie en fonction des motifs complexes à obtenir. L'utilisation simultanée de plusieurs microélectrodes lors de la mise en oeuvre du procédé permet de réaliser rapidement des motifs gravés complexes sur une même surface. Des solutions électrochimiques, identiques ou différentes, peuvent être utilisées dans cette variante. Avantageusement, une seule et même solution électrochimique est employée.

Fait intéressant, les inventeurs ont remarqué que le procédé selon la présente invention peut être mis en oeuvre sur un support multi-couche. En effet, le support peut présenter non seulement une couche d'oxyde métallique conducteur directement déposée sur le support, mais également au moins une autre couche d'un matériau conducteur, semi-conducteur ou isolant déposé sur cette couche d'oxyde métallique conducteur.

La mise en oeuvre du procédé permet, dans ce cas de figure, de graver la couche d'oxyde métallique conducteur et l'autre couche de matériau, alors que la gravure d'une couche de matériau isolant, semi-conducteur ou conducteur directement déposée sur le support i.e. en absence de la couche d'oxyde métallique conducteur n'est pas forcément possible avec le procédé selon l'invention.

La (ou les) couche(s) déposée(s) sur la couche d'oxyde métallique conducteur est(sont) mince(s). Elle(s) présente(nt) une épaisseur qui peut être variable sur toute la surface de la couche d'oxyde métallique conducteur. Toutefois, une épaisseur constante sur toute la surface de la couche d'oxyde métallique conducteur est avantageuse. En particulier, cette épaisseur est comprise entre 10 et 1000 nm, notamment entre 20 et 800 nm, en particulier, entre 50 et 600 nm et, plus particulièrement, entre 100 et 400 nm.

A titre d'exemples de matériaux isolants, semi-conducteurs ou conducteurs susceptibles d'être déposés sur la couche d'oxyde métallique conducteur, on peut citer des semi-conducteurs de type n ou de type p, notamment choisis dans le groupe constitué par l'oxyde de titane (TiO₂), l'oxyde de nickel (NiO), l'oxyde d'indium éventuellement dopé, l'oxyde de zinc éventuellement dopé, l'oxyde d'étain éventuellement dopé, l'oxyde de cadmium éventuellement dopé, l'oxyde de gallium éventuellement dopé, l'oxyde de thallium éventuellement dopé, l'oxyde de plomb éventuellement dopé, l'oxyde d'antimoine éventuellement dopé, l'oxyde de magnésium éventuellement dopé, l'oxyde de titane éventuellement dopé, l'oxyde de nobium éventuellement dopé, l'oxyde de tungstène éventuellement dopé, l'oxyde de zirconium et leurs mélanges ; du fluorure de graphite, de l'oxyde de silicium; du nitrure de silicium ; un matériau organique, notamment choisi dans le groupe constitué par les matériaux photoémetteurs tels que l'8-hydroxy-quinoline complexant un métal (ZnQ₂, AlQ₃) ou la polyaniline ; les matériaux injecteurs de charges tels que la 4,4'-Bis{N-phényl-N-(4-méthylphényl)amino}biphényl, 2, ou 4-[N-(4-Hydroxyméthylphényl)-N-(4-méthylphényl)amino]-4'-[Nphényl- N- 4-méthylphényl)amino]biphényl, 4; les polymères, les zéolites et les nanotubes.

L'homme du métier connaît différents protocoles permettant d'obtenir le dépôt d'une couche d'un matériau tel que précédemment défini sur une couche d'oxyde métallique conducteur. A titre d'exemples illustratifs et non limitatifs de tels protocoles, on peut citer le spin-coating, le casting, l'électrogreffage, le greffage chimique et la déposition par évaporation.

Le procédé selon la présente invention est mis en oeuvre à une température comprise entre 4 et 50°C, notamment entre 10 et 40°C, en particulier, entre 20 et 30°C et, plus particulièrement, à température ambiante. Par « température ambiante », on entend, dans le cadre de la présente invention, une température de 22°C ± 3°C.

Le procédé selon la présente invention peut ainsi notamment être réalisé dans une cellule d'électrolyse comportant différentes électrodes : une première électrode de travail correspondant à la couche d'oxyde métallique (si cette dernière est polarisée), une seconde électrode de travail correspondant à la microélectrode, une contre électrode telle qu'une feuille de platine ainsi qu'une électrode de référence commune tel qu'un fil d'argent.

Selon une disposition particulière, plusieurs microélectrodes peuvent être employées simultanément au-dessus d'une même couche d'oxyde métallique conducteur.

Le procédé selon la présente invention peut être mis en oeuvre pour la fabrication d'électrodes, ou d'éléments conducteurs dans différents domaines. Ainsi, dans l'industrie verrière, la présente invention peut être mise en oeuvre pour fabriquer des réseaux conducteurs pour vitrage chauffant par effet Joule ou des vitrages incorporant des antennes.

La présente invention peut également être mise en oeuvre dans l'industrie des cellules photovoltaïques et dans l'industrie électronique en vue de fabriquer des faces avant ou des faces arrière d'écrans émissifs du type écran plat, écran dit plasma ou encore des écrans tactiles et plus généralement tout type de d'écran/vitrage susceptible de recevoir, de transmettre ou d'émettre des rayonnements, notamment de la lumière visible.

L'invention concerne également l'utilisation d'une microélectrode pour graver une zone sélectionnée d'une couche d'un oxyde métallique conducteur notamment tel que précédemment défini, déposée sur un support. Plus particulièrement, la présente invention concerne l'utilisation d'une microélectrode pour graver une zone sélectionnée d'une couche d'un oxyde métallique conducteur notamment tel que précédemment défini, déposée sur un support et mise en présence d'une solution électrochimique, notamment telle que précédemment définie.

La présente invention concerne également une couche d'un oxyde métallique conducteur gravée susceptible d'être obtenue par gravure d'une couche d'oxyde métallique conducteur déposée sur un substrat selon un procédé conforme à la présente invention. En effet, dans le cas où la couche d'oxyde métallique est polarisée (i.e. connectée), la couche gravée conserve toutes les caractéristiques de la couche d'oxyde métallique conducteur de départ et présente une gravure nette aussi bien au niveau des bordures que du fond de la gravure et se distingue donc, de ce fait, des autres couches gravées obtenues par les procédés de l'état de la technique.

L'invention sera mieux comprise à la lecture des exemples qui suivent et qui font référence aux figures annexées. Ces exemples n'ont d'autre but que d'illustrer la présente invention et ne doivent en aucune manière être compris comme une limitation de sa portée.

### BRÈVE DESCRIPTION DES DESSINS

La Figure 1 est la représentation schématisée déjà commentée du procédé selon la présente invention.
La Figure 2 présente la largeur de la gravure de la couche d'ITO exprimée en µm, en fonction du potentiel imposé à la microélectrode (Eᵤₘₑ) exprimé en V.
La Figure 3 présente le courant exprimé en mA passant dans les électrodes que sont la microélectrode (Iᵤₘₑ) et le substrat i.e. la couche d'ITO (I_{SUB}) en fonction du potentiel imposé à la microélectrode (Eᵤₘₑ) exprimé en V.
La Figure 4 présente la largeur de la zone gravée de la couche d'ITO exprimée en µm, en fonction du potentiel imposé à la surface i.e. à la couche d'ITO (Eₛ) exprimé en V.
La Figure 5 présente la largeur de la zone gravée (l) exprimée en µm, en fonction de la distance de travail (WD) entre la microélectrode et la couche d'ITO exprimée entre µm. Les valeurs sont présentées pour deux expériences indépendantes (1) et (2).
La Figure 6 présente la quantité de courant (I) mesurée dans la microélectrode exprimée en mA, en fonction de la distance de travail (WD) entre la microélectrode et la couche d'ITO exprimée entre µm. Les valeurs sont présentées pour deux expériences indépendantes (1) et (2).
La Figure 7 présente une image par microscopie à force atomique d'une couche d'ITO déposée sur du verre et gravée selon le procédé de gravure de la présente invention.
La Figure 8 présente deux conformations mises en oeuvre lors de la gravure de la couche d'ITO, avec la couche d'ITO qui est, soit connectée, soit déconnectée.
La Figure 9 présente un fil (ou trait en relief) d'ITO généré par gravure d'une couche d'ITO selon le procédé de la présente invention. La Figure 9A présente les deux zones gravées présentant une inclinaison relative de 3° générant un espace qui définit le fil d'ITO. La Figure 9B est un détail de cet espace généré par les deux zones gravées i.e. un détail du fil d'ITO.
La Figure 10 est un exemple d'un motif gravé en utilisant le procédé de gravure selon la présente invention, puis son application par la réalisation d'une OLED (pour « Organic Light Emitting Diode » ou Diode organique électroluminescente).

### EXPOSÉ DÉTAILLÉ DE MODES DE RÉALISATION PARTICULIERS

### 1. Protocole de lithographie.

Une couche d'ITO d'une épaisseur de 200 nm (15 Ω/carré) a été déposée sur une lame de verre puis a été gravée de façon à modeler un circuit électrique. En variante, une couche d'ITO d'une épaisseur de 250 nm a été déposée sur une membrane de polyéthylène téréphtalate (PET).

Différents potentiels appliqués à la couche d'ITO et à la microélectrode ont été testés (point 4 ci-après). Pour les autres expérimentations, la microélectrode de SECM (UME) a été polarisée, avec le bipotentiostat, à un potentiel positif élevé de 7 V et la surface de ITO à - 0,1 V.

Différentes distances de travail i.e. distances entre la pointe de la microélectrode et la couche d'ITO ont été testées (point 3 ci-après).

La surface sur laquelle a été déposée la couche d'ITO polarisée a été immergée dans une solution pour laquelle différentes compositions ont été testées (point 2 ci-après). Dans cette solution, se trouvent également une électrode de référence commune (RE, fil d'argent) et une contre-électrode (CE, feuille de platine).

Dans ces conditions, la microélectrode a pu être déplacée à une vitesse de 300 µm/sec pour former une gravure uniforme sur le verre recouvert d'ITO. Il a pu être vérifié que la zone gravée présente un caractère isolant typique du verre, ce qui confirme l'élimination totale de la couche d'ITO sur cette zone.

### 2. Solutions électrochimiques testées.

### 2.1. Composition chimique des solutions testées.

Différentes solutions électrochimiques (ou électrolytiques) avec, comme solvant, de l'eau ont été testées. Le Tableau 1 ci-après reprend les compositions de ces solutions.

**Tableau 1**

| Solution | K₂SO₄ | H₂SO₄ | AA¹ | AAc² | HEMA³ | dₙ⁴ |
|---|---|---|---|---|---|---|
| 1 | 0,25 M | | | | | 12,8 |
| 2 | | 0,25 M | | | | 8 |
| 3 | | | 2 M | | | 2 |
| 4 | 0,25 M | | 2 M | | | 5, 6 |
| 5 | | 0,25 M | 2 M | | | 5 |
| 6 | | 0,25 M | | 2 M | | 5 |
| 7 | 0,25 M | | | | 2 M | 11,6 |

| | | | | | | |
|---|---|---|---|---|---|---|
| ¹ : Acide Acrylique ² : Acide Acétique ³ : (2-hydroxyéthyl) méthacrylate ⁴ : Largeur / rayon_{UME} | | | | | | |

### 2.2. Résultats obtenus avec les différentes solutions testées.

Une solution acide ne contenant que de l'acide sulfurique (H₂SO₄) n'est pas capable d'enlever tout le matériel dans la cavité générée lors de la gravure. Le facteur de forme dₙ se définit comme la largeur de la gravure sur le rayon de la microélectrode UME mise en oeuvre : dₙ = largeur / rayon_{UME}. Dans le cas où la solution aqueuse mise en oeuvre ne contient que de l'acide sulfurique, le dₙ est élevé puisque égal à 8 pour 7 V imposés à la microélectrode.

Lorsque la solution aqueuse contient à la fois de l'acide sulfurique (0,25 M) et de l'acide acrylique (2 M) (solution 4), l'efficacité de cette solution est évidente vu l'homogénéité et la précision du motif gravé. Dans la zone traitée, aucun résidu appréciable n'a été observé et le dₙ est égal à 5 pour 7 V imposés.

Pour tester la contribution de chacun des éléments de la solution 4, la solution 5 dans laquelle l'acide acrylique a été remplacé par de l'acide acétique a été préparée. Utilisant de l'acide acétique, le groupement carboxylique est conservé alors que l'influence vinylique est perdue. Dans ce cas, la taille de la gravure est équivalente puisque dₙ est égal à 5 mais il reste du matériel résiduel sur les bords de la cavité générée.

L'acide acrylique permet donc d'obtenir de meilleurs résultats essentiellement dus à l'élimination des résidus d'ITO lors de la gravure. Sans vouloir être tenu à une quelconque théorie, l'acide acrylique semble jouer un rôle de complexant vis-à-vis de l'indium et de l'étain libérés lors de la gravure.

### 3. Observations électrochimiques.

Différents potentiels imposés aux électrodes ont été testés dans la gamme de 1 à 10 V pour la microélectrode UME et dans la gamme de 0 à -0,5 V pour la couche d'ITO.

L'analyse de la taille (ou largeur) de la gravure en fonction du potentiel imposé à la microélectrode UME montre que le procédé commence à un potentiel de 3 V (Figure 2). Cette information est confirmée par l'analyse du courant à travers les électrodes (Figure 3).

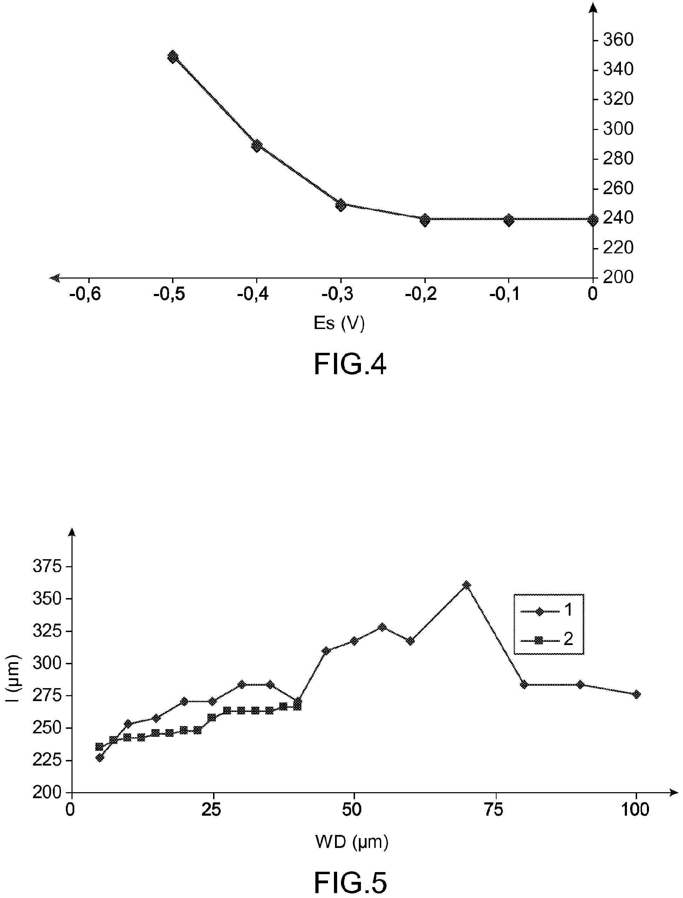

L'analyse de la taille de la gravure en fonction du potentiel imposé à la couche d'ITO montre que plus le potentiel est négatif, plus la taille est élevée (Figure 4). Des potentiels imposés à la couche d'ITO plus négatifs tels que -1 V engendrent une dégradation définitive de la surface.

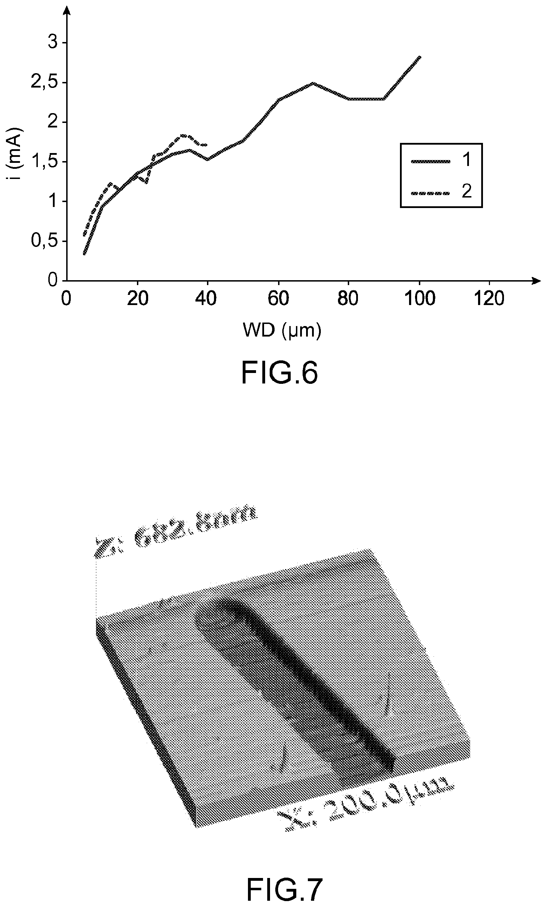

Différentes distances de travail i.e. distance entre la microélectrode UME et la couche d'ITO ont été testées, un potentiel de 7 V et un potentiel de - 0,1 V étant respectivement imposés à la microélectrode UME et à la couche d'ITO. De plus, l'expérimentation a été répétée deux fois afin d'en apprécier la répétabilité. Les résultats présentés à la Figure 5 montrent l'épaisseur de la zone gravée en fonction de la distance de travail et la répétabilité des résultats obtenus. De même, cette répétabilité peut également être mise en évidence en mesurant le passage du courant en fonction de la distance de travail (Figure 6).

### 4. Le modelage ou « patterning ».

Une série de modèles ont été réalisés de façon à tester la reproductibilité, la résolution et les performances électriques.

Les caractérisations morphologiques et chimiques ont permis de déterminer l'efficacité du procédé selon la présente invention. La netteté des bordures et du fond (surface du support) de la zone gravée a été vérifiée par spectroscopie de photoélectrons X (XPS) et par microscopie à force atomique (AFM).

La spectroscopie de photoélectrons X (XPS) est la meilleure technique pour déterminer les différentes concentrations atomiques à une profondeur de 10 nm dans une surface. Le Tableau 2 ci-après reprend les pourcentages atomiques pour différents éléments mesurés au niveau de la zone gravée conformément au procédé selon la présente invention (Zone gravée) et au niveau de la couche d'ITO déposée sur du verre et entourant la zone gravée (Zone entourant).

**Tableau 2**

| Elément | Zone gravée | Zone entourant |
|---|---|---|
| O | 52,8 | 33,6 |
| Sn | 0,1 | 2,2 |
| In | 0,4 | 20,4 |
| N | 2,4 | 0,6 |
| C | 13,2 | 41,9 |
| Si | 31,1 | 1,2 |

La zone gravée a une composition typique de verre, alors que la zone entourant cette zone gravée a une composition d'ITO non changée.

L'image d'AFM présentée à la Figure 7 confirme la netteté de la zone gravée et des bordures. Le bord de 200 nm est substantiellement vertical et exempt de toute impureté résultant du procédé. La netteté est maintenue dans la zone gravée et dans la zone entourant la zone gravée, garantissant les meilleures performances du matériel électrique.

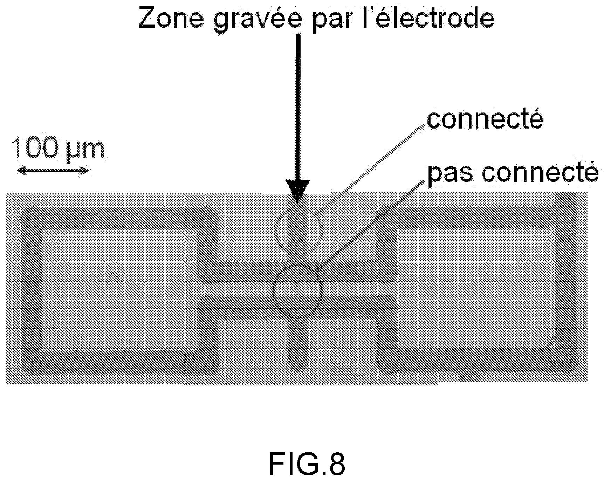

Ainsi, dans les circuits, deux modes différents peuvent être utilisés: avec zone d'ITO connectée ou avec zone d'ITO déconnectée (Figure 8). La déconnection du substrat ou d'une partie de ce dernier va rendre passive l'évolution du potentiel du substrat. La surface va perdre son rôle d'électrode et les modifications arriveront par le bombardement des espèces en provenance de la ME.

Avec l'isolement de la zone de travail (mode déconnecté), une bonne localisation de la gravure est obtenue puisque dₙ est égal à 2,5. Toutefois, la surface est modifiée: elle a perdu une partie de ses caractéristiques physico-chimiques initiales, à savoir soit une perte de transparence, soit une perte de conductivité électrique, soit les deux.

La résolution a été testée avec les deux modes.

Lorsque le procédé est mis en oeuvre avec une surface connectée, il est plus reproductible.

Dans la seconde approche (mode déconnecté), il est plus difficile de maintenir une bonne uniformité de la zone gravée. Cette approche reste cependant utilisable.

Différentes géométries ont été testées pour étudier le procédé de gravure selon la présente invention.

Il est possible d'isoler, sur un support recouvert par une couche d'ITO, un carré d'ITO en gravant une zone carrée conformément au procédé de l'invention. Le support a été soumis à un électrogreffage avec une molécule susceptible d'être détectée telle qu'un photosensibilisateur basé sur un complexe Ru(II) polyazahétérocyclique. Les résultats obtenus montrent que cet électrogreffage n'est possible que sur la zone d'ITO entourant le carré qui est polarisée. Le carré d'ITO étant isolé, il n'est plus soumis à la polarisation et ne peut subir l'électrogreffage. L'électrogreffage n'est possible que moyennant la polarisation directe du carré d'ITO.

Le procédé selon la présente invention permet d'isoler des domaines d'ITO et, de façon plus générale, des domaines d'oxyde métallique conducteur. Ces domaines peuvent être électrogreffés avec des polymères distincts pour créer une surface avec des motifs fonctionnalisés distincts.

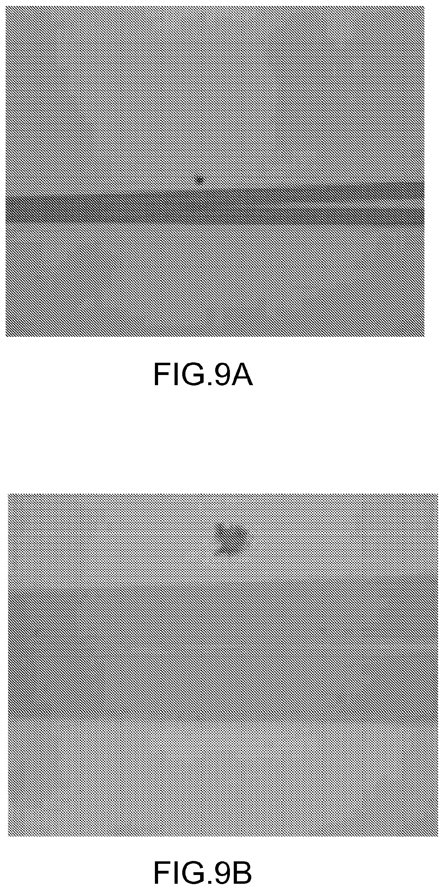

En utilisant le mode connecté, deux lignes avec une inclinaison relative d'environ 3° ont été réalisées en gravant la couche d'ITO (Figure 9A). Le fil (ou trait en relief) d'ITO le plus fin possible susceptible d'être obtenu avec une microélectrode UME de 25 µm a été créé à l'intersection des deux lignes (Figure 9B).

La résolution maximale du fil d'ITO ainsi obtenu a été étudiée par microscopie à force atomique (AFM). La continuité du fil est garantie jusqu'à une largeur de 10 µm et même jusqu'à 3 µm.

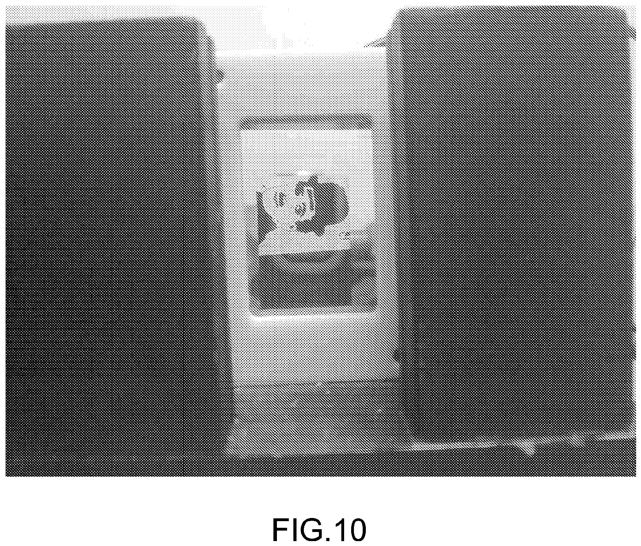

Un exemple d'un motif gravé en utilisant un procédé selon la présente invention et son application en tant qu'OLED est présenté à la Figure 10. La lithographie, assistée par un logiciel de dessins pour créer le motif, est realisée par SECM sur une couche d'ITO déposée sur verre selon la présente invention. La surface du motif est d'un centimère carré. Après réalisation de la gravure, l'évaporation de couches organiques nous a permis de réaliser une OLED selon le procédé décrit dans **[5].**

### RÉFÉRENCES

**[1].** Article de Cheng et al., « ITO patterning by a low power Q-switched green laser and its use in the fabrication of a transparent flow meter » J. Micromech. Microeng. 17 (2007) 2316-2323.
**[2].** Article de Wang et al., « Toward mimicking biological vision with protein-based flexible imaging arrays » SPIE Newsroom (2006) DOI: 10.1117/2.1200611.0468.
**[3].** Article de Huang et al., « The effect of solvent on the etching of ITO electrode » Materials Chemistry and Physics, 84 (2004) 146-150.
**[4].** Article de Chen et al., « Laser direct write patterning technique of indium tin oxide film » Thin Solid Films, 515 (2007) 8515-8518.
**[5].** Article de Zucchi et al., « White electroluminescence of lanthanide complexes resulting from exciplex formation » J. Mater. Chem., 20 (2010) 2114-2120.
**[6].** Demande de brevet FR 2 813 208 « Structure complexante, dispositif et procédé de traitement d'effluents liquides », déposée au nom du CEA et publiée le 1^{er} mars 2002.
**[7].** Demande de brevet FR 2 851 181 « Procédé de revêtement d'une surface », déposée au nom du CEA et publiée le 20 août 2004.

## Revendications

1. Procédé pour graver une zone sélectionnée d'une couche d'un oxyde métallique conducteur déposée sur un support consistant à éliminer ladite zone par voie électrochimique en présence d'une microélectrode polarisée et d'une solution électrochimique.

2. Procédé selon la revendication 1, **caractérisé en ce que** ledit oxyde métallique conducteur est un oxyde transparent et conducteur (OTC).

3. Procédé selon la revendication 1 ou 2, **caractérisé en ce que** ledit oxyde métallique conducteur est choisi dans le groupe constitué par un oxyde d'indium éventuellement dopé, un oxyde d'étain éventuellement dopé, un oxyde de zinc éventuellement dopé, un oxyde de cadmium éventuellement dopé, un oxyde de gallium éventuellement dopé, un oxyde de thallium éventuellement dopé, un oxyde de plomb éventuellement dopé, un oxyde d'antimoine éventuellement dopé, un oxyde de niobium éventuellement dopé, un oxyde de tungstène éventuellement dopé, un oxyde de zirconium éventuellement dopé, un oxyde de ruthénium éventuellement dopé, un oxyde de baryum éventuellement dopé, un oxyde de sélénium éventuellement dopé, un oxyde de bismuth éventuellement dopé et leurs mélanges.

4. Procédé selon l'une quelconque des revendications 1 à 3, **caractérisé en ce que** ledit oxyde métallique conducteur est de l'oxyde d'indium dopé à l'étain (ITO).

5. Procédé selon l'une quelconque des revendications 1 à 4, **caractérisé en ce que** ladite microélectrode est choisie dans le groupe constitué par une ultramicroélectrode (UME), la sonde d'un microscope électrochimique à balayage (SECM) et la sonde d'un microscope à force atomique en mode électrochimique (AFM-SECM).

6. Procédé selon l'une quelconque des revendications précédentes, **caractérisé en ce qu'**il comprend les étapes suivantes :
a) positionnement de ladite microélectrode à proximité de la surface de ladite zone sélectionnée ;
b) mise en contact d'une solution électrochimique avec au moins ladite zone sélectionnée ;
c) polarisation de ladite microélectrode et éventuellement de ladite couche d'oxyde métallique conducteur,
la séquence d'étapes étant soit (a), (b) et (c), soit (a), (c) et (b).

7. Procédé selon la revendication 6, **caractérisé en ce que** ladite étape (c) consiste en la polarisation de ladite microélectrode et de ladite couche d'oxyde métallique conducteur.

8. Procédé selon l'une quelconque des revendications précédentes, **caractérisé en ce que** ladite solution électrochimique comprend au moins un acide carboxylique, avantageusement choisi dans le groupe constitué par l'acide carbonique, l'acide acétique, l'acide propanoïque, l'acide butanoïque, l'acide acrylique, l'acide méthacrylique, l'acide méthyl méthacrylique, l'acide éthacrylique, l'acide alpha-chloroacrylique, l'acide alpha-cyano acrylique, l'acide crotonique, l'acide alpha-phényl acrylique, l'acide sorbique, l'acide alpha-chloro sorbique, l'acide angélique, l'acide cinnamique, l'acide p-chloro cinnamique, l'acide itaconique, l'acide citraconique, l'acide mésaconique, l'acide glutaconique, l'acide aconitique, l'acide fumarique, le tricarboxy éthylène, l'acide oxalique, l'acide maléique, l'acide benzène tétracarboxylique, l'acide 1,2,3,4-butane tétracarboxylique et l'acide 1,2,3-propane tricarboxylique.

9. Procédé selon l'une quelconque des revendications précédentes, **caractérisé en ce que** ladite solution électrochimique comprend au moins un acide faible, avantageusement présentant un pKa supérieur à 4, notamment compris entre 4 et 13 et, en particulier, entre 4 et 9.

10. Procédé selon l'une quelconque des revendications précédentes, **caractérisé en ce que** ladite solution électrochimique comprend au moins un composé apte à chélater (complexer) au moins un ion métallique.

11. Procédé selon l'une quelconque des revendications précédentes, **caractérisé en ce que** ladite solution électrochimique comprend un solvant protique avantageusement choisi dans le groupe constitué par l'eau, l'eau désionisée, l'eau distillée, l'eau acidifiée, l'eau désionisée acidifiée et l'eau distillée acidifiée.

12. Procédé selon l'une quelconque des revendications précédentes, **caractérisé en ce que** la couche d'oxyde métallique conducteur étant une couche d'ITO, le potentiel imposé à la microélectrode est supérieur à 3 V, notamment compris entre 4 et 10 V et, en particulier, de l'ordre de 7 V.

13. Procédé selon l'une quelconque des revendications 7 à 12, **caractérisé en ce que** la couche d'oxyde métallique conducteur étant une couche d'ITO, le potentiel imposé à ladite couche d'ITO est supérieur à - 1 V, notamment compris entre 0 et - 1 V et, en particulier, de l'ordre de - 0,1 V.

14. Procédé selon l'une quelconque des revendications précédentes, **caractérisé en ce qu'**il comporte une étape supplémentaire de déplacement de la microélectrode à proximité de la zone sélectionnée de la couche d'oxyde métallique conducteur.

15. Procédé selon l'une quelconque des revendications précédentes, **caractérisé en ce que** ledit support présente non seulement une couche d'oxyde métallique conducteur directement déposée sur le support, mais également au moins une autre couche d'un matériau conducteur, semi-conducteur ou isolant déposé sur cette couche d'oxyde métallique conducteur.

16. Utilisation d'une microélectrode pour graver une zone sélectionnée d'une couche d'un oxyde métallique conducteur déposée sur un support et mise en présence d'une solution électrochimique.

17. Couche d'un oxyde métallique conducteur gravée selon un procédé tel que défini à l'une quelconque des revendications 7 à 15.

## Patentansprüche

1. Verfahren zum Ätzen einer ausgewählten Zone einer Schicht aus leitendem Metalloxid, die auf einem Träger aufgebracht ist, umfassend das Entfernen der Zone auf elektrochemischem Weg in Anwesenheit einer polarisierten Mikroelektrode und einer elektrochemischen Lösung.

2. Verfahren nach Anspruch 1, **dadurch gekennzeichnet, dass** das leitende Metalloxid ein transparentes und leitendes Oxid (OTC) ist.

3. Verfahren nach Anspruch 1 oder 2, **dadurch gekennzeichnet, dass** das leitende Metalloxid ausgewählt ist aus der Gruppe gebildet durch ein gegebenenfalls dotiertes Indiumoxid, ein gegebenenfalls dotiertes Zinnoxid, ein gegebenenfalls dotiertes Zinkoxid, ein gegebenenfalls dotiertes Kadmiumoxid, ein gegebenenfalls dotiertes Galliumoxid, ein gegebenenfalls dotiertes Thalliumoxid, ein gegebenenfalls dotiertes Bleioxid, ein gegebenenfalls dotiertes Antimonoxid, ein gegebenenfalls dotiertes Nioboxid, ein gegebenenfalls dotiertes Wolframoxid, ein gegebenenfalls dotiertes Zirkonoxid, ein gegebenenfalls dotiertes Rutheniumoxid, ein gegebenenfalls dotiertes Bariumoxid, ein gegebenenfalls dotiertes Selenoxid, ein gegebenenfalls dotiertes Wismutoxid und ihre Mischungen.

4. Verfahren nach einem der Ansprüche 1 bis 3, **dadurch gekennzeichnet, dass** das leitende Metalloxid Indiumoxid ist, das mit Zinn dotiert ist (ITO).

5. Verfahren nach einem der Ansprüche 1 bis 4, **dadurch gekennzeichnet, dass** die Mikroelektrode ausgewählt ist aus der Gruppe gebildet durch eine Ultramikroelektrode (UME), die Sonde eines elektrochemischen Rastermikroskops (SECM) und die Sonde eines Rasterkraftmikroskops im elektrochemischen Modus (AFM-SECM).

6. Verfahren nach einem der vorhergehenden Ansprüche, **dadurch gekennzeichnet, dass** es die folgenden Schritte umfasst:
a) Positionieren der Mikroelektrode in der Nähe der Oberfläche der ausgewählten Zone;
b) Inkonktaktbringen einer elektrochemischen Lösung mit wenigstens der ausgewählten Zone;
c) Polarisieren der Mikroelektrode und gegebenenfalls der leitenden Metalloxidschicht,
wobei die Reihenfolge der Schritte entweder (a), (b) und (c) oder (a), (c) und (b) ist.

7. Verfahren nach Anspruch 6, **dadurch gekennzeichnet, dass** der Schritt (c) das Polarisieren der Mikroelektrode und der leitenden Metalloxidschicht umfasst.

8. Verfahren nach einem der vorhergehenden Ansprüche, **dadurch gekennzeichnet, dass** die elektrochemische Lösung wenigstens eine Carboxylsäure umfasst, vorzugsweise ausgewählt aus der Gruppe gebildet durch Kohlensäure, Essigsäure, Propansäure, Butansäure, Acrylsäure, Methacrylsäure, Methylmethacrylsäure, Ethacrylsäure, Alpha-Chloroacrylsäure, Alpha-Cyanacrylsäure, Krotonsäure, Alpha-Phenylacrylsäure, Sorbinsäure, Alpha-Chlorsorbinsäure, Angelicasäure, Zimtsäure, p-Chlorzimtsäure, Itaconsäure, Citraconsäure, Mesaconsäure, Glutaconsäure, Aconitsäure, Fumarsäure, Tricarboxyethylen, Oxalsäure, Maleinsäure, Benzoltetracarboxylsäure, 1,2,3,4-Butantetracarboxylsäure, und 1,2,3-Propantricarboxylsäure.

9. Verfahren nach einem der vorhergehenden Ansprüche, **dadurch gekennzeichnet, dass** die elektrochemische Lösung wenigstens eine schwache Säure umfasst, die vorzugsweise einen pKa größer als 4 aufweist, insbesondere enthalten zwischen 4 und 13, und spezieller zwischen 4 und 9.

10. Verfahren nach einem der vorhergehenden Ansprüche, **dadurch gekennzeichnet, dass** die elektrochemische Lösung wenigstens eine Verbindung enthält, die dazu ausgelegt ist, wenigstens ein Metallion zu chelatieren (komplexieren).

11. Verfahren nach einem der vorhergehenden Ansprüche, **dadurch gekennzeichnet, dass** die elektrochemische Lösung ein protisches Lösungsmittel umfasst, das vorzugsweise ausgewählt ist aus der Gruppe gebildet durch Wasser, entionisiertes Wasser, destilliertes Wasser, angesäuertes Wasser, entionisiertes angesäuertes Wasser und destilliertes angesäuertes Wasser.

12. Verfahren nach einem der vorhergehenden Ansprüche, **dadurch gekennzeichnet, dass** die leitende Metalloxidschicht eine ITO-Schicht ist, wobei das an die Mikroelektrode angelegte Potential größer als 3 V ist, insbesondere enthalten zwischen 4 und 10 V, und spezieller in der Größenordnung von 7 V.

13. Verfahren nach einem der Ansprüche 7 bis 12, **dadurch gekennzeichnet, dass** die leitende Metalloxidschicht eine ITO-Schicht ist, wobei das an die ITO-Schicht angelegte Potential größer als -1 V ist, insbesondere enthalten zwischen 0 und -1 V, und spezieller in der Größenordnung von -0,1 V.

14. Verfahren nach einem der vorhergehenden Ansprüche, **dadurch gekennzeichnet, dass** es einen zusätzlichen Schritt der Verlagerung der Mikroelektrode in die Nähe der ausgewählten Zone der leitenden Metalloxidschicht umfasst.

15. Verfahren nach einem der vorhergehenden Ansprüche, **dadurch gekennzeichnet, dass** der Träger nicht nur eine leitende Metalloxidschicht aufweist, die direkt auf den Träger aufgebracht ist, sondern auch wenigstens eine weitere Schicht aus einem leitenden, halbleitenden oder isolierenden Material, das auf dieser leitenden Metalloxidschicht aufgebracht ist.

16. Verwendung einer Mikroelektrode zum Ätzen einer ausgewählten Zone einer leitenden Metalloxidschicht, die auf einem Träger aufgebracht und in Anwesenheit einer elektrochemischen Lösung gebracht ist.

17. Leitende Metalloxidschicht, die gemäß einem Verfahren wie in einem der Ansprüche 7 bis 15 definiert geätzt ist.

## Claims

1. A method for etching a selected area of a conductive metal oxide layer deposited on a support, consisting in removing said area via electrochemical route in the presence of a polarized microelectrode and an electrochemical solution.

2. The method according to claim 1 **characterized in that** said conductive metal oxide is a transparent conductive oxide (TCO).

3. The method according to claim 1 or 2 **characterized in that** said conductive metal oxide is chosen from the group consisting of an optionally doped indium oxide, optionally doped tin oxide, optionally doped zinc oxide, optionally doped cadmium oxide, optionally doped gallium oxide, optionally doped thallium oxide, optionally doped lead oxide, optionally doped antimony oxide, optionally doped niobium oxide, optionally doped tungsten oxide, optionally doped zirconium oxide, optionally doped ruthenium oxide, optionally doped barium oxide, optionally doped selenium oxide, optionally doped bismuth oxide, and mixtures thereof.

4. The method according to any of claims 1 to 3 **characterized in that** said conductive metal oxide is tindoped indium oxide (ITO).

5. The method according to any of claims 1 to 4 **characterized in that** said microelectrode is chosen from the group consisting of an ultramicroelectrode (UME), the probe of a scanning electrochemical microscope (SECM) and the probe of an atomic force microscope in electrochemical mode (AFM-SECM).

6. The method according to any of the preceding claims **characterized in that** it comprises the following steps:
a) positioning said microelectrode close to the surface of said selected area;
b) contacting an electrochemical solution with at least said selected area;
c) polarizing said microelectrode and optionally said conductive metal oxide layer,
the sequence of steps being either (a), (b) and (c), or (a), (c) and (b).

7. The method according to claim 6 **characterized in that** said step (c) consists in polarizing said microelectrode and said conductive metal oxide layer.

8. The method according to any of the preceding claims **characterized in that** said electrochemical solution comprises at least a carboxylic acid, advantageously chosen from the group consisting of carbonic acid, acetic acid, propanoic acid, butanoic acid, acrylic acid, methacrylic acid, methyl methacrylic acid, ethacrylic acid, alpha-chloroacrylic acid, alpha-cyano acrylic acid, crotonic acid, alpha-phenyl acrylic acid, sorbic acid, alpha-chloro sorbic acid, angelic acid, cinnamic acid, p-chloro cinnamic acid, itaconic acid, citraconic acid, mesaconic acid, glutaconic acid, aconitic acid, fumaric acid, tricarboxy ethylene, oxalic acid, maleic acid, benzene tetracarboxylic acid, 1,2,3,4-butane tetracarboxylic acid and 1,2,3-propane tricarboxylic acid.

9. The method according to any of the preceding claims **characterized in that** said electrochemical solution comprises at least one weak acid, advantageously having a pKa higher than 4, in particular of between 4 and 13, and more particularly between 4 and 9.

10. The method according to any of the preceding claims **characterized in that** said electrochemical solution comprises at least one compound capable of chelating (complexing) at least one metal ion.

11. The method according to any of the preceding claims **characterized in that** said electrochemical solution comprises a protic solvent advantageously chosen from the group consisting of water, deionized water, distilled water, acidified water, acidified deionized water and acidified distilled water.

12. The method according to any of the preceding claims **characterized in that** the conductive metal oxide layer being an ITO layer, the potential applied to the microelectrode is higher than 3 V, in particular between 4 and 10 V and more particularly of the order of 7 V.

13. The method according to any of claims 7 to 12 **characterized in that** the conductive metal oxide layer being an ITO layer, the potential applied to said ITO layer is higher than - 1 V, and in particular is between 0 and - 1 V and more particularly of the order of - 0.1 V.

14. The method according to any of the preceding claims **characterized in that** it comprises an additional step to move the microelectrode close to the selected area of the conductive metal oxide layer.

15. The method according to any of the preceding claims **characterized in that** said support not only has a conductive metal oxide layer deposited on the support, but also at least one other layer of conductor, semiconductor or insulating material deposited on this conductive metal oxide layer.

16. The use of a microelectrode for etching a selected area of a conductive metal oxide layer deposited on a support and placed in the presence of an electrochemical solution.

17. A conductive metal oxide layer etched using the method such as defined in any of claims 7 to 15.
